(19) **Europäisches Patentamt / European Patent Office / Office européen des brevets**

(11) **EP 2 077 453 A1**

(12) **EUROPÄISCHE PATENTANMELDUNG**

(43) Veröffentlichungstag:
**08.07.2009 Patentblatt 2009/28**

(51) Int Cl.:
***G01R 31/26*** (2006.01)     ***G05F 1/67*** (2006.01)

(21) Anmeldenummer: **07024889.3**

(22) Anmeldetag: **01.01.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA HR MK RS**

(71) Anmelder: **SMA Solar Technology AG**
**34266 Niestetal (DE)**

(72) Erfinder: **Drews, Peter**
**34128 Kassel (DE)**

(74) Vertreter: **Walther, Walther & Hinz GbR**
**Heimradstrasse 2**
**34130 Kassel (DE)**

Bemerkungen:
Geänderte Patentansprüche gemäss Regel 137(2) EPÜ.

(54) **Auswerteverfahren**

(57) Mit einem Auswerteverfahren zur Bestimmung einer durch Alterung hervorgerufenen Leistungsreduzierung von mindestens einem Photovoltaikmodul bei gleichbleibender Strahlungsintensität mit einer Messung einer nach einer Zeit veränderbaren elektrischen Größe wie Zellenstrom, Zellenspannung und/oder Zellenleistung soll eine langfristige Leistungsreduzierung von Solarmodulen in einer installierten Solaranlage in einfacher Weise und mit hoher Genauigkeit bestimmt werden. Dies wird erreicht durch Festlegung mindestens einer jahresweise vergleichbaren Klasse k, innerhalb der eine Tagesleistungskurve oder Teilbereiche der Tagesleistungskurve des Photovoltaikmoduls bei gleichen Strahlungsparametern vergleichbar sind, wobei die Klasse k einem definierten Zeitbereich eines Jahres entspricht, durch Bestimmung von jahresweise vergleichbaren Energieertragswerten Ek,n und/oder einem vergleichbaren Leistungsverlauf Pk,n(t) durch die vom Photovoltaikgenerator gelieferte Größe, so dass Energie- und/oder Leistungsabweichungen auf Basis der Klassen k bestimmt werden, wobei n das jeweilige Jahr ist, sowie durch Angabe einer Leistungsreduzierung des Photovoltaikmoduls bezüglich eines oder mehrerer Vorjahre des von dem Photovoltaikmodul unmittelbar gelieferten Energieertragwertes und/oder der gelieferten Leistung P(t) durch eine Differenzbildung des Energieertrages und/oder der Leistung der zu vergleichenden Jahre.

Fig. 2b

EP 2 077 453 A1

**Beschreibung**

Die Erfindung betrifft ein Auswerteverfahren zur Bestimmung einer durch Alterung hervorgerufenen Leistungsreduzierung von mindestens einem Photovoltaikmodul bei gleichbleibender Strahlungsintensität mit einer Messung einer nach einer Zeit veränderbaren elektrischen Größe wie Zellenstrom, Zellenspannung und/oder Zellenleistung.

Solarzellen bzw. Photovoltaikmodule unterliegen einer Alterung hinsichtlich ihrer Leistung. Der Verlust an Wirkungsgrad liegt in einem Zeitraum von 20 Jahren im Bereich von 10 % bis 20 %.

Für die Montage werden Solarzellen in Modulen, sogenannten Solar- bzw. Photovoltaikmodulen oder Solarpanelen zusammengefasst. So hat ein Solarmodul z.B. nach 20 Jahren nur noch 90 % bis 80 % seiner angegebenen Leistung.

Bekannt sind Verfahren, die auf künstlich beschleunigten Alterungstests basieren. Diese Tests werden nur für bestimmte Bedingungen, beispielsweise Temperatur und Einstrahlung durchgeführt und sind daher in der Regel mit Sicherheitsfaktoren belegt. Die von einem Hersteller garantierte Wirkungsgradangabe nach einer bestimmten Zeit ist daher in der Regel geringer als die tatsächliche Wirkungsgradreduzierung. Für solche Tests werden außerdem zusätzliche Sensoren eingesetzt, die beispielsweise die Temperatur- oder Einstrahlungsintensität erfassen.

In der Praxis ist der Leistungsverfall des Solarmoduls über die Zeit nur sehr schwer nachzuvollziehen. Es ist schwer feststellbar, ob der Leistungsverfall sich innerhalb der Grenzen der Herstellerangaben bewegt, da hierzu bestimmte Rahmenbedingungen notwendig sind, wie eine bestimmte Außentemperatur, genaue Sensoren bzw. eichfähige Einstrahlungssensoren und dergleichen.

Der Erfindung liegt die Aufgabe zugrunde, ein Verfahren der eingangs genannten Art zu finden, mit dem eine langfristige Leistungsreduzierung von Solarmodulen in einer installierten Solaranlage in einfacher Weise und mit hoher Genauigkeit bestimmt werden kann.

Diese Aufgabe durch folgende Verfahrensschritte gelöst:

- Festlegung mindestens einer jahresweise vergleichbaren Klasse k, innerhalb der eine Tagesleistungskurve oder Teilbereiche der
Tagesleistungskurve des Photovoltaikmoduls bei gleichen
Strahlungsparametern vergleichbar ist, wobei die Klasse k einem definierten Zeitbereich entspricht,

- Messung von jahresweise vergleichbaren Energieertragswerten
und/oder einem vergleichbaren Leistungsverlauf durch die vom Photovoltaikgenerator gelieferte Größe, so dass Energie- und/oder
Leistungsabweichungen auf Basis der Klassen k bestimmt werden, wobei n das jeweilige Jahr ist,

- Angabe einer Leistungsreduzierung des Photovoltaikmoduls bezüglich eines oder mehrerer Vorjahre des von dem Photovoltaikmodul unmittelbar gelieferten Energieertragwertes und/oder der gelieferten
Leistung durch eine Differenzbildung des Energieertrages und/oder der
Leistung der zu vergleichenden Jahre.
Weitere vorteilhafte Ausgestaltungen der Erfindung sind in den Unteransprüchen gekennzeichnet.

Durch das erfindungsgemäße Messverfahren ist es möglich, eine langfristige Leistungsreduzierung sehr genau zu bestimmen, ohne dass zusätzliche Sensoren erforderlich sind.

Die Erfindung beruht auf der Erkenntnis, dass vergleichbare Tage bezüglich Strahlungsintensität und Temperatur der Solaranlage über mehrere Jahre hinweg gefunden werden können, die aufgrund ihrer Vergleichbarkeit eine zuverlässige Aussage hinsichtlich der Leistungsreduzierung zulassen. Um eine Vergleichbarkeit hinsichtlich Einstrahlung sicherzustellen, ist es möglich, über die Jahre hinweg Tage miteinander zu vergleichen, an denen der Verlauf beispielsweise einer Leistungskurve P (t) nahezu gleich ist. Da die Einstrahlungsintensität und Einstrahlungsdauer über den Jahresverlauf schwanken, wird das Jahr in mehrere Zeiträume, d.h. in mehrere Klassen k, eingeteilt. Beispielsweise kann k = 52 sein, so dass der Vergleich wöchentlich vorgenommen werden kann. Der eigentliche Vergleich erfolgt dann nur innerhalb einer Klasse k über die Jahre n hinweg.

Der Erfindung liegt also der Gedanke zugrunde, den Energieertrag der Solaranlage über mehrere Jahre zu beobachten. Aktuelle Daten werden mit Vorjahreswerten verglichen. Damit ist feststellbar, in welcher Weise der Energieertrag über die Jahre hinweg abnimmt.

In jedem Jahr sind die Tage zu finden, an denen der Energieertrag der Solaranlage mit Vorjahreswerten vergleichbar ist, um eine zuverlässige Aussage hinsichtlich der Leistungsreduzierung zu treffen.

Pro Jahr n können also maximal k Energiewerte vorliegen. Diese Energiewerte können mit den Energiewerten eines Vorjahres, beispielsweise mit denen des Vorjahres oder des ersten Jahres verglichen werden. Die Differenz der Energiewerte, beispielsweise, ist ein Maß für die Leistungsreduktion. Diese Differenz kann normiert werden. Als Norm kann der Energiebetrag des Vorjahres dienen.

Die Leistungsreduktion kann somit durch die Erfindung innerhalb einer Klasse über die Jahre beobachtet werden. Eine Solaranlage kann somit durch die genaue Messung auch ohne Wartungsarbeiten länger an ein Netz angeschlossen werden. Es ist auch möglich, frühzeitig eine erhöhte Leistungsreduktion festzustellen, so dass Photovoltaikmodule rechtzeitig ausgetauscht werden können.

Zur Messung des Energieertrages kann eine Größe des Generators wie der Generatorstrom, die Generatorspannung oder die Generatorleistung gemessen werden.

In einer vorteilhaften Ausführungsform des erfindungsgemäßen Messverfahrens ist vorgesehen, dass mindestens zwei über das Jahr verteilte Klassen k vorhanden sind, innerhalb derer die Tagesleistungskurven oder der Teilbereich der Tagesleistungskurven aufgrund der zu erwartenden Einstrahlungsintensität und der Außentemperatur sowie der Einstrahlungsdauer vergleichbar sind. Dadurch kann berücksichtigt werden, dass die zu erwartende Einstrahlungsintensität und Außentemperatur sowie die Einstrahlungsdauer jahreszeitig bedingt schwankt.

Besonders vorteilhaft ist das Erfassen oder Ablegen einer Tagesverlaufskurve der Leistung P des Generators sowie des Energieertrages E des Photovoltaikgenerators des Tages, wobei eine Tagesleistungskurve P(t) bestimmt wird, die in ihrem Verlauf mit mindestens einer Tageskurve Pk,n(t) aus den Vorjahren vergleichbar ist. Vorteilhaft ist also eine Messung des Tagesverlaufs der Leistung des Solargenerators P(t) sowie des Tagesenergieertrages Etag, d.h. also beider Größen. Diese Werte können aufgezeichnet und in einer Datenbank zum Beispiel mittels eines Datenloggers abgelegt werden. Innerhalb jeder Klasse k kann pro Jahr n eine Tagesleistungskurve Pk,n(t) bestimmt werden, die in ihrem Verlauf mit den Tagesleistungskurven Pk,i(t) aus den Vorjahren i vergleichbar ist. Dies bedeutet auch, dass pro Jahr maximal k Energieertragswerte Ek,n ermittelt werden, die mit den Energieertragswerten Ek,i der Vorjahre i, beispielsweise den Erstjahreswerten Ek,1 verglichen werden, so dass maximal k Werte für die Energieabweichungen ΔEk,n bestimmt werden. Es wird mindestens eine dieser Energieabweichungen ΔEk,n bezogen auf einen Energieertragswert Ek,i eines Vorjahres, beispielsweise des Erstjahres Ek,1 für die Angabe der Leistungsreduzierung des Solargenerators verwendet.

Innerhalb jeder Klasse wird daher ein Tag bzw. ein Messzeitraum ermittelt, dessen Leistungskurve P(t) und Energieertrag E mit an früheren Tagen vorgenommenen Messungen vergleichbar sind.

Es ist vorteilhaft, dass Tagesklassen kj der Anzahl ktmax gebildet werden. Die Tagesklassen entsprechen Zeitbereichen, die festen Zeitintervallen zugeordnet sind und die über den zu erwartenden Sonnenscheinzeitraum des Tages verteilt sind. Dieser Vergleich erfolgt dann zwischen Messintervallen, die sowohl gleiche k wie kj Klassen aufweisen. Eine Klasse kann auch eine Klasse mit einem gleichen Koeffizientenpaar (k, kj) bzw. gleichem Tupel sein. Bei der auf Tagesklassen erweiterten Variante liegen dann maximal k*kj Energiewerte E((k,kj),n) vor, die mit den Energiewerten der Vorjahre verglichen werden. Differenz- und Mittelwertbildungen sind hier möglich.

In einer vorteilhaften Ausführungsform der Erfindung werden vergleichbare Tage innerhalb einer Klasse in maximal zwei Schritten bestimmt, und zwar dadurch, dass die erste Ableitung Pk' (t) der Funktion Pk(t) gebildet und ausgewertet wird.

In einer ersten wird die erste Ableitung Pk' (t) der Datenschaar Pk(t) gebildet und beispielsweise auf Einhaltung bestimmter Grenzwerte hin überprüft. Bei Unter- oder Überschreitung der Grenzwerte kann von einem Tag ohne Bewölkung ausgegangen werden.

Alternativ wird die erste Ableitung Pk'(t) gebildet und ausgewertet, indem eine von ihr eingeschlossenen Kurvenfläche auf festgelegte Grenzwerte hin untersucht wird. ausgewertet. In einem ersten Schritt geht dann die erste Ableitung Pk'(t) in ein Auswerteverfahren ein, aus dem sich Werte ergeben, die vorgegebene Grenzwerte nicht unter- oder überschreiten dürfen.

Mit Hilfe eines Plausibilitätskriteriums kann in einem zweiten Schritt eindeutig bestimmt werden, ob tatsächlich ein Tag ohne Bewölkung vorliegt.

Zum Beispiel kann ein Plausibilitätskriterium das Vorliegen von Messdaten aus der Datenschr Pk(t) innerhalb von Toleranzbändern sein, wie ein Toleranzband für eine bestimmte Region oder ein Toleranzband für Sommertage und eines für Wintertage. Das heißt, dieses Plausibilitätskriterium wird beispielsweise auf die Datenschaar P(t) angewandt.

Ein alternatives Plausibilitätskriterium wird auf den Energieertrag Ek,tag angewandt. Der Energieertrag Ek,tag darf ebenfalls einen vorgegebenen Grenzwert nicht unterschreiten.

Zweckmäßigerweise werden alternativ oder zusätzlich in einer weiteren Ausgestaltung Nulldurchgänge der ersten Ableitung Pk'(t) ausgewertet. Ein Tag ohne Bewölkung liegt eindeutig vor, wenn nur ein Nulldurchgang vorliegt. Dieses Auswerteverfahren ist in nur einem Schritt durchführbar.

Es ist außerdem sinnvoll, Grenzwerte im ersten Jahr vorzugeben und diese Grenzwerte in den folgenden Jahren zu verifizieren.

In einer weiteren bevorzugten Weiterbildung des erfindungsgemäßen Verfahrens ist vorgesehen, dass mindestens ein Mittelwert ΔEmittel aus den k Energieabweichungswerten ΔEk,n für das Jahr n als Maß für die Leistungsreduzierung ermittelt wird. Durch die Mittelwertbildung ist eine sehr genaue Aussage über den Alterungszustand der Solarzellen möglich.

Vorteil bei dieser Vorgehensweise ist, dass sich dabei erhaltene Quotienten bzw. Prozentwerte sowohl für die k als auch für die kj Klassen, also Tages und Wochenwerte, mitteln lassen. So ergibt sich eine sehr breite statistische Basis, die eine gute Genauigkeit der Werte garantiert.

Besonders günstig ist es, wenn eine Tagesleistungskurve bestimmt wird, die im Wesentlichen nur ein Tagesleistungsmaximum aufweist. Dieser Fall tritt ein, wenn ein wolkenfreier Tag vorhanden ist. In dieser Variante der Erfindung werden nur Energiewerte aus Messzeiträumen verglichen, in denen keine Verschattung auftritt. Die Erkennung der Verschattung kann mit den oben genannten Verfahren realisiert werden.

Bei dieser Variante werden Zeitbereiche mit Verschattung erkannt, indem die durch vorbeiziehende Wolken verursachte Helligkeitsänderung bewertet wird. Es wird im Prinzip die Änderung der Helligkeit festgestellt, indem insbesondere die Ableitung der von der Solaranlage erzeugten Leistung nach der Zeit gebildet wird. Hohe Werte einer solchen Ableitung werden durch einen Bewertungsalgorithmus ausgewertet, der ermittelt, ob der Zeitbereich der Messung durch Bewölkung beeinflusst wurde. Hierbei ist es günstig, dass eine Bewertungsnorm durch feste oder adaptive Schwellwerte implementiert wird. Es kann eine Bewertungsnorm mit Betragsmittelwerten, quadratischen Mittelwerten oder anderen Werten eingesetzt werden. Vorteilhaft ist es, wenn ein Zeitbereich mit Verschattung erkannt wird, indem der Betrag der im Zeitbereich erzeugten Leistung oder der Energie mit einem Vergleichswert verglichen wird. Zeigen sich signifikante Abweichungen nach unten, so bestand eine Verschattung. Ein solcher Vergleichswert kann aus einem Modell der Einstrahlung eines wolkenfreien Tages erzeugt werden. Weiterhin ist eine Ermittlung eines Vergleichswertes aus den Einstrahlungswerten vorhergehender Tage möglich, insbesondere wenn diese entsprechenden Zeitintervalle als wolkenfrei erkannt wurden. Günstig ist es, wenn ein Vergleichswert aus gespeicherten Werten vorhergehender Jahre ermittelt wird.

Ein Ausführungsbeispiel wird anhand der Zeichnungen näher erläutert, wobei weitere vorteilhafte Weiterbildungen der Erfindung und Vorteile derselben beschrieben sind.

Es zeigen:

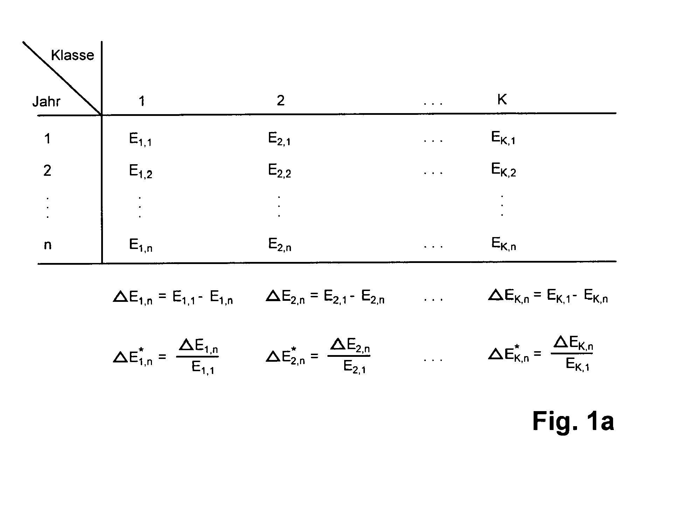

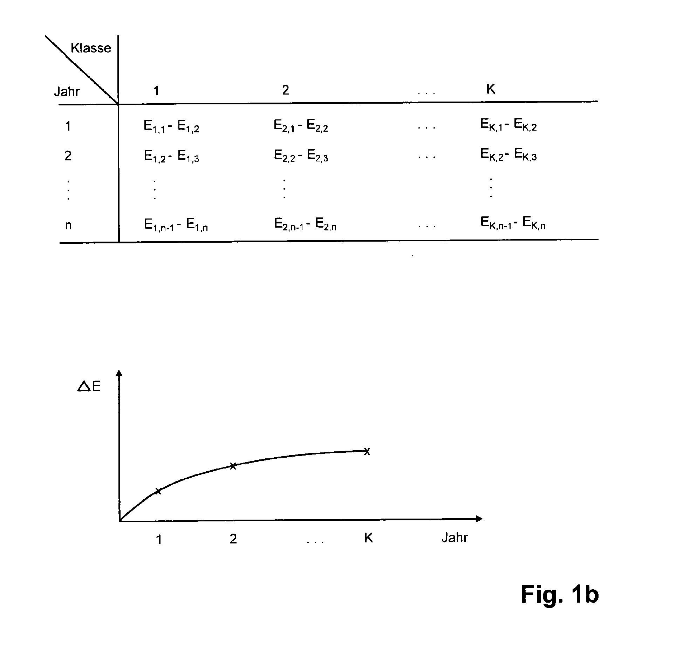

Fig. 1 a    eine Matrix für mehrere Jahre 1 bis n sowie mehrere Klassen 1 bis k, in der Energieerträge aufgeführt sind,

Fig. 1 b    eine mit Figur 1 a vergleichbare Matrix, bei der jedoch die Energieabweichungen aufgeführt sind,

Fig.2a    einen gemessenen Verlauf der Leistung P eines Photovoltaikgenerators für einen Tag ohne Wolken,

Fig. 2b    einen prinzipiellen Verlauf der Kurve gemäß Fig. 2a,

Fig. 2c    einen Verlauf der ersten Ableitung für die in Fig. 2b gezeigte Funktion,

Fig. 3a    einen gemessenen Verlauf der Leistung P des Photovoltaikgenerators für einen Tag mit vorüberziehenden Wolken,

Fig. 3b    einen prinzipiellen Verlauf der Leistung gemäß Fig. 3a für den Tag mit vorüberziehenden Wolken,

Fig. 3c    einen Verlauf der ersten Ableitung für die in Figur 3b gezeigten Funktion,

Fig. 4a    einen gemessenen Verlauf der Leistung P des Photovoltaikgenerators für einen bewölkten Tag,

Fig. 4b    den prinzipiellen Verlauf der Leistung P für diesen Tag mit bedecktem Himmel,

Fig. 4c    einen Verlauf der ersten Ableitung für die in Fig. b gezeigte Funktion.

Figur 1a veranschaulicht eine Matrix mit Energieertragsdaten für mehrere Jahre 1 bis n, die in den Matrix Zeilen aufgeführt sind, sowie für mehrere Klassen 1 bis k, die in den Spalten aufgeführt sind. Die unter der Matrix stehenden Formeln geben die Energieabweichungen pro Klasse k und für das jeweilige Jahr n an. Pro Jahr n liegen dann k Energiewerte $E_{k,n}$ vor. Diese Energiewerte $E_{k,n}$ können dann mit den Energiewerten $E_{k,i}$ des Vorjahres i, eines beliebigen Vorjahres oder des ersten Jahres verglichen werden. Die Differenz $\Delta E_{k,n} = E_{k,i} - E_{k,n}$ wird als Maß für die Leistungsreduktion bestimmt. Diese Differenz kann normiert sein. Als Norm kann beispielsweise der Energieertrag des Vorjahres i dienen, so dass die Leistungsreduktion durch $\Delta E_{k,n} / E_{k,i} = (E_{k,i} - E_{k,n}) / E_{k,i}$ ausgedrückt werden kann. Damit kann eine Leistungsreduktion der Photovoltaikmodule innerhalb einer Klasse über mehrere Jahre beobachtet werden.

In Fig. 1a bedeuten also $\Delta E_{1,n}$ bis $\Delta E_{k,n}$ Energieabweichung pro Klasse. $\Delta E^*_{1,n}$ bedeuten normierte Energieabweichungen pro Klasse, was später näher erläutert wird.

Erfindungsgemäß basiert das Verfahren auf einer Messung bzw. auf einer Erfassung des Tagesverlaufs der Leistung des Solargenerators P(t) sowie einem Tagesenergieertrag Etag. Diese Daten können in einer Datenbank abgelegt werden.

Über das Jahr verteilt sind mehrere Klassen k vorhanden. Mindestens jedoch sind zwei Klassen k erforderlich. Dies ist günstig, um eine jahreszeitabhängige Einstrahlungsintensität sowie eine jahreszeitlich abhängige Außentemperatur zu berücksichtigen.

Innerhalb jeder Klasse k wird pro Jahr n eine Leistungskurve $P_{k,n}(t)$ bestimmt, die in ihrem Verlauf mit den Tagesleistungskurven $P_{k,i}$ aus den Vorjahren i vergleichbar ist.

D.h. pro Jahr werden maximal k Energieertragswerte $E_{k,n}$ ermittelt, die mit den Energieertragswerten $E_{k,i}$ der Vorjahre, beispielsweise den Energieertragswerten $E_{k,1}$ verglichen werden, so dass maximal k Werte für die Energieabweichungen $\Delta E_{k,n}$ bestimmt werden.

Mindestens eine dieser Energieabweichungen $\Delta E_{k,n}$ bezogen auf einen Energieertragswert $E_{k,i}$ eines Vorjahres i, beispielsweise des Erstjahreswertes $E_{k,1}$ wird für die Angabe der Leistungsreduzierung des Photovoltaikgenerators verwendet.

Bevorzugterweise werden die Energieerträge auf einen Tag bezogen. D.h., innerhalb jeder Klasse wird ein Tag ermittelt, dessen Leistungskurve P(t) und Energieertrag E mit an früheren Tagen vorgenommenen Messungen vergleichbar sind. Pro Jahr n liegen dann k Energiewerte $E_{k,n}$ vor, die sich auf einen Tag beziehen. Diese Tagesenergiewerte $E_{k,n}$ können mit den Tagesenergiewerten $E_{k,n-1}$ des Vorjahres oder mit den Energiewerten $E_{k,1}$ des ersten Jahres bzw. auch eines beliebigen Jahres verglichen werden.

In Figur 1b ist eine weitere Matrix dargestellt, die die Energieabweichungen für mehrere Jahre 1 bis n sowie für alle Klassen 1 bis k umfasst. Unterhalb der Matrix ist eine Messgrafik dargestellt, in der die Energieabweichungen $\Delta E$ bezogen auf die Jahre 1 bis n dargestellt sind.

Aus diesen Größen können Mittelwerte aus allen k Energieabweichungen $\Delta(E_{k,n})$ für ein Jahr n ermittelt werden, und zwar mit der Formel:

$$\Delta E_{mittel, n} = \frac{1}{k} \cdot \sum_{m=1}^{k} \Delta E_{m,n}$$

Für normierte Energieabweichungen nimmt die oben genannte Formel die Form an:

$$\Delta E^*_{mittel, n} = \frac{1}{k} \cdot \sum_{m=1}^{k} \Delta E^*_{m,n}$$

Die Werte $\Delta E_{mittel,n}$ bzw. $\Delta E^*_{mittel,n}$ geben dann einen Jahresmittelwert für die Leistungsreduktion des Photovoltaikgenerators im jeweiligen Jahr n an.

Möglich ist auch, dass quadratische Mittelwerte oder eines Mittelwertes hoch p d.h. $\Delta(E_{k,n})^p$ bzw. $\Delta(E_{(k,kj),n})^p$ betrachtet werden. Dadurch ist eine signifikante Werteänderung möglich, über die der Alterungsprozess der Zellen normiert werden kann. Günstig ist es, wenn p eine Konstante zwischen 2 und 6 ist.

Nachfolgend wird ein Feststellungsvorgang für vergleichbare Tage beschrieben.

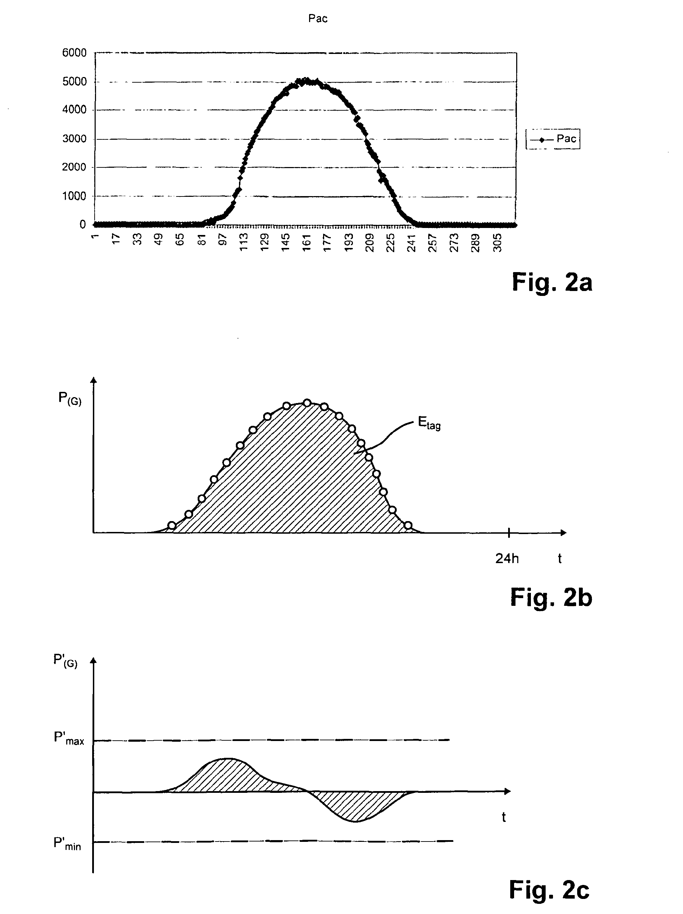

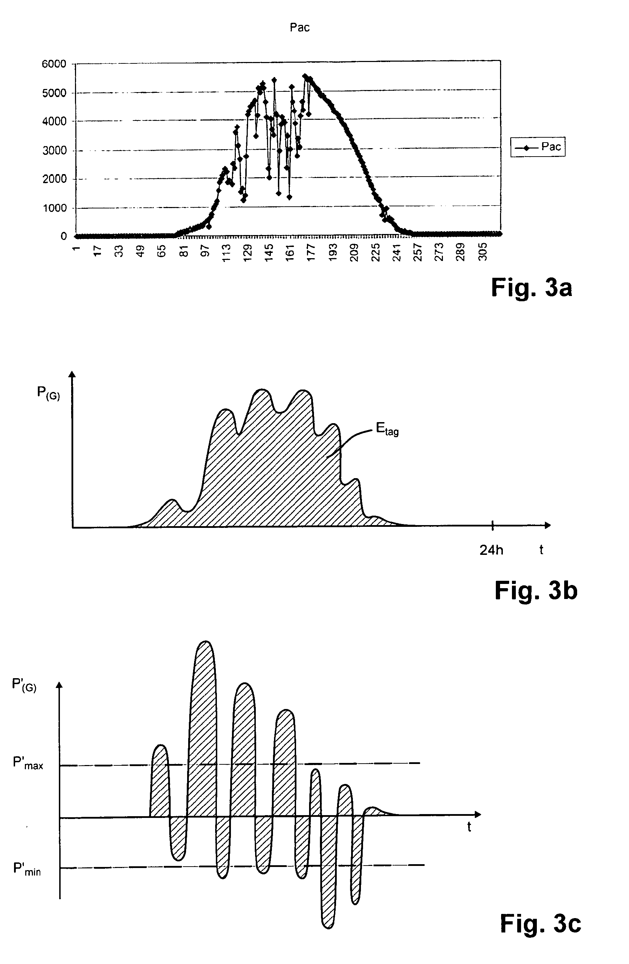

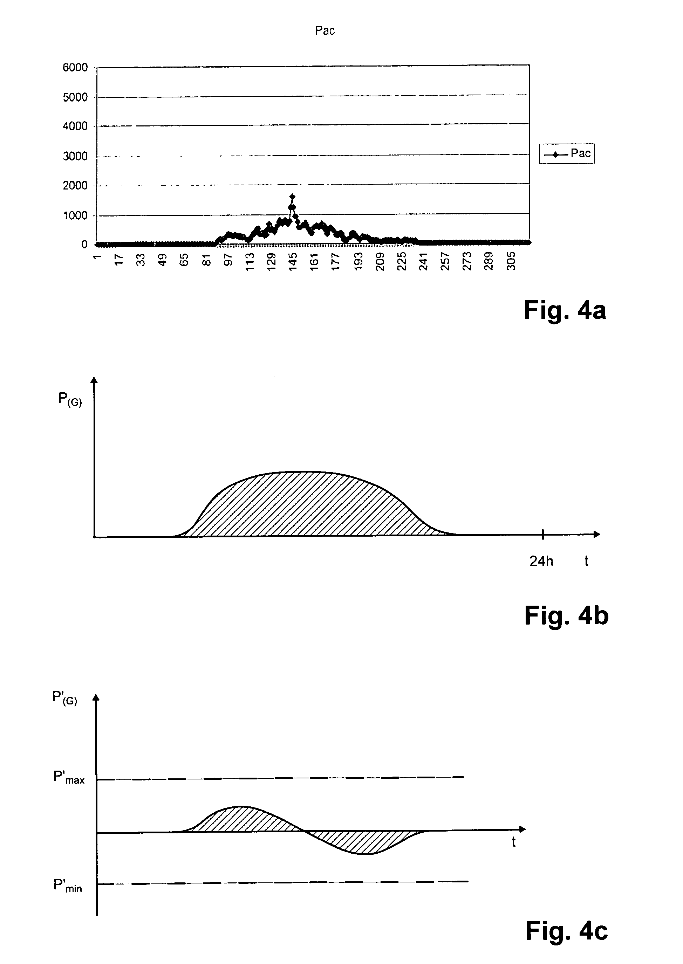

Die Figuren 2a, 3a und 4a zeigen verschiedene Tagesleistungskurven P(t) für verschiedene Wetterbedingungen. In Fig. 2a basiert die gemessene Leistungskurve auf einem wolkenfreien Tag. In Fig. 3a ist ein gemessener Verlauf der Leistung P des Solargenerators in Abhängigkeit von der Zeit für einen Tag mit vorüberziehenden Wolken dargestellt, wobei zeitweise die Sonne durch Wolkenlücken den Photovoltaikgenerator bestrahlt. In Fig. 4a bezieht sich der gemessene Verlauf der Leistung P des Solargenerators auf einen stark bewölkten Tag bzw. einen Tag mit konstant schwacher Sonneneinstrahlung.

Wie Fig. 2a zeigt, steigt mit Sonnenaufgang die Strahlungsleistung der Sonne an. Um die Mittagszeit erreicht sie ihr Maximum. In Richtung des Sonnenunterganges fällt die Strahlung wieder zu Null. Fig. 2a veranschaulicht also einen gemessen Verlauf der Leistung P eines Photovoltaikgenerators bzw. eines oder mehrerer Photovoltaikmodule in Abhängigkeit von der Zeit t für einen wolkenfreien Tag. Wie der Kurve zu entnehmen ist, ist lediglich ein Tagesmaximum bezüglich der Leistung P vorhanden. Leistungseinbrüche durch vorbeiziehende Wolken sind nicht vorhanden

In Fig. 3a ist ersichtlich, dass starke Leistungsschwankungen vorliegen. Die durch vorbeiziehende Wolken veränderte Strahlungsintensität auf die Photovoltaikmodule ist gut zu erkennen.

Wenn ein Tag eine Kurve gemäß Fig. 4a hervorruft, dann liegt zum Beispiel ein bewölkter oder regnerischer Tag vor, wobei die Sonneneinstrahlung verhältnismäßig gering ist. Dies kann typischerweise ein Tag im Winter sein.

Die Figuren 2a, 3a und 4a zeigen also typische gemessene Leistungskurven P(t) für Tage mit unterschiedlicher Witterung, wobei diese in diskreter Form vorliegen, d.h. tatsächliche Messgrößen darstellen. Zur Vereinfachung sind in den Figuren 2b, 3b und 4b diese Funktionen als kontinuierliche Funktionen bzw. prinziphaft dargestellt. Die diskret vorliegenden Messdaten können durch geeignete Interpolationsverfahren auch in kontinuierliche Funktionen überführt werden.

Bevorzugterweise wird in einem ersten Schritt pro Tag die erste Ableitung P'(t) der Leistungskurve P (t) gebildet und ausgewertet, wie die Figuren 2c, 3c und 4c zeigen.

Fig. 2b zeigt den sonnigen Tag ohne Wolken. Es werden über den Tag verteilt eine Vielzahl von Messergebnissen in einer Datenbank abgespeichert. Diese Ergebnisse sind in der Kurve durch Messpunkte auf der Kurve dargestellt. Die Kurve hat ein Tagesmaximum, das typischerweise um die Mittagszeit liegt. Die Fläche unter der Kurven entspricht dem Kurvenintegral bzw. der Energie.

Die Fig. 3b zeigt prinziphaft den Leistungsverlauf bei vorüberziehenden Wolken. Einer Basiskurve, die der Kurve in Fig. 2b entspricht, sind eine Art Oberwellen überlagert, die durch die zeitweise Verdunklung der Wolken zustande kommen.

Um eine Leistungsreduzierung des Solarmoduls mit sehr hoher Genauigkeit bestimmen zu können, werden also bevorzugterweise Daten mit vergleichbarer Leistungskurve P(t) des Photovoltaikmoduls bzw. der Solaranlage über mehrere Jahre hinweg beobachtet. Aufgrund ihrer Vergleichbarkeit ist eine zuverlässige Aussage über die Leistungsreduzierung des Photovoltaikmoduls möglich. Grundsätzlich eignen sich für einen Vergleich Tage mit kompletter Bewölkung, wie in Fig. 4a oder 4b veranschaulicht ist, oder Tage mit zeitweiser Bewölkung, die durch vorbeiziehende Wolken gekennzeichnet sind, wie in den Figuren 3a bzw. 3b gezeigt ist. Bevorzugterweise wird jedoch ein Vergleich mit Tagen ohne Bewölkung angestrebt, d.h. ein Kurvenverlauf nach Fig. 2a oder 2b jahresweise verglichen.

Das Messverfahren nutzt vorzugsweise die Leistungskurve P(t) sowie auch den Energieertrag E, der der durch die Kurve eingeschlossenen Fläche entspricht. Diese Fläche ist in den Figuren 2b, 3b und 4b schraffiert. Beides wird ausgewertet. Durch dieses Messverfahren sind zusätzliche Informationen, wie beispielsweise eine Außentemperatur oder Einstrahlungsdaten, nicht erforderlich. Auch sind Sensoren nicht nötig, da die Leistungsdaten aus der gelieferten Größe des Photovoltaikmoduls gemessen werden. Gemessen werden kann eine Spannung, ein Strom oder beides. Auch ist eine direkte Leistungsmessung möglich.

Die Figuren 2c bis 4c zeigen die erste Ableitung P'(t) der Funktionen, die in den Figuren 2b bis 4b dargestellt sind.

In Fig. 4b ist ein Beispiel für den Verlauf der Leistung des Photovoltaikgenerators in Abhängigkeit von der Zeit (t) für einen Tag mit bedecktem Himmel dargestellt. In Fig. 4c ist beispielsweise die zugehörige erste Ableitung nach der Zeit dargestellt. Im Unterschied zum wolkenfreien Tag kann der Maximalwert der Leistung Pmax jedoch deutlich geringer sein.

In einem ersten Schritt wird die Funktion P'(t) gebildet.

Die erste Ableitung P'(t) kann auf verschiedene Weise ausgewertet werden. Die Auswertung liefert einen deutlichen Hinweis darauf, ob ein wolkenfreier Tag vorliegt oder nicht, wie Fig. 3c zeigt.

In einem zweiten Schritt wird nämlich dann untersucht und sichergestellt, ob tatsächlich ein wolkenfreier Tag gefunden wurde. Dafür wird die Leistungskurve P(t) oder ihre erste Ableitung P'(t) ausgewertet. Vorzugsweise werden also zwei Auswerteschritte genutzt, um in zuverlässiger Weise einen vergleichbaren wolkenfreien Tag zu ermitteln.

In einem der Schritte wird die erste Ableitung P'(t) ausgewertet. Hierzu gibt es zwei Möglichkeiten der Auswertung der ersten Ableitung P'(t). Eine erste Möglichkeit basiert darauf, dass das Auswerteverfahren für P'(t) auf einer Untersuchung eines Maximums basiert. Liegt der Maximalwert P'max, wie Fig. 2c zeigt, beispielsweise unterhalb einer vorgegebenen Grenze (obere) gestrichelte Linie oder der Minimalwert P'min oberhalb einer vorgegebenen Grenze P'min (untere gestrichelte Linie), wird dann ein Tag ohne Wolken vermutet.

Wie Fig. 3c zeigt, hat die erste Ableitung der Leistungskurve für einen Tag mit vorüberziehenden Wolken einen sehr viel höheren Maximalwert P'max aber auch einen viel niedrigeren Minimalwert P'min als die in Fig. 2c gezeigte erste Ableitung der Leistungskurve für einen wolkenfreien Tag. In den Figuren 2c, 3c und 4c sind die obere Grenze P'max und die untere Grenze P'min ebenfalls als gestrichene Linien dargestellt. Solche Grenzwerte können auch für bestimmte Regionen definiert werden. Dies ist möglich, weil mittlere Einstrahlungswerte für alle Regionen in einem Land grundsätzlich bekannt sind. Da Einstrahlungswerte nicht nur für Regionen, sondern auch z.B. für bestimmte Städte bekannt sind, ist eine Feinabstimmung möglich. Diese Grenzwerte werden vorteilhafterweise im ersten Betriebsjahr der Anlage für z.B. einen wolkenfreien Tag ermittelt und festgesetzt. Eine Verifizierung wird im Laufe der Jahre dann vorgenommen. So können auch langfristige klimatische Änderungen einer Region durch Klimawandel berücksichtigt werden.

Wie die Fig. 4c veranschaulicht, liegen die Werte der ersten Ableitung der Leistungskurve für einen bedeckten Tag ebenfalls unterhalb bzw. oberhalb der vorgegebenen Grenzen. Ohne weiteres kann ein weiteres Kriterium herangezogen werden, um zweifelsfrei und automatisch einen Tag ohne Wolken festzustellen. Dies ist günstig, weil ein über den Tagesverlauf komplett mit Wolken verhangener Tag eine ähnliche Tagesleistungskurve P(t) ergibt, wie ein wolkenloser Tag.

Eine zweite Möglichkeit der Auswertung der ersten Ableitung P'(t) wird im Folgenden beschrieben. Bei dieser Variante des Auswerteverfahrens, wird P'(t) ebenfalls pro Tag aus der Leistungskurve P (t) gebildet.

Für jeden Tag wird dann beispielsweise das Integral

$$I = \frac{1}{Tag} \int_{Tag} \left( \frac{dP'(t)}{dt} \right)^2 dt$$

bestimmt.

Wenn der ermittelte Wert I unterhalb eines maximal zulässigen Grenzwertes I_max liegt, so dass I < I_max ist, dann kann angenommen werden, dass ein wolkenfreier Tag vorliegt, der in die Berechnung der Leistungsreduktion eingehen kann. Dieser Grenzwert ergibt sich aus typischen Einstrahlungswerten und ist abhängig z.B. von der geographischen Lage. Die Festsetzung des entsprechenden Tages erfolgt dann nach dem gleichen Muster wie in dem vorangegangenen Beispiel des Auswerteverfahrens von P'(t).

Das Integral I ist ein Maß für die von der ersten Ableitung P'(t) eingeschlossenen Fläche. Ein Vergleich der Figuren 2c und 4c verdeutlicht, dass die von der Kurve eingeschlossene Fläche an einem bewölkten Tag deutlich kleiner ist. Diese Fläche wird durch das Integral I bestimmt. Das heißt, ist I < I_max, dann kann auch ein bewölkter Tag vorliegen. Daher ist es zweckmäßig, einen weiteren Auswerteschritt vorzunehmen.

In einer weiteren Möglichkeit der Auswertung der ersten Ableitung P'(t) werden jedoch nur die Nulldurchgänge der P'(t) Kurve betrachtet. Liegt beispielsweise ein wolkenfreier Tag vor, dann ist die Anzahl der Nulldurchgänge der Kurve P(t) gleich 1. Dieser Nulldurchgang findet im Zeitpunkt des Leistungsmaximums statt, wie Fig. 2c zeigt. Werden mehr als ein Nulldurchgang, wie in Fig. 3c veranschaulicht, festgestellt, dann ist davon auszugehen, dass kein wolkenfreier Tag vorliegt.

Im Folgenden wird der zweite Schritt der Auswertung der Leistungskurve P(t) näher beschrieben.

Da im ersten Schritt zunächst nur vermutet wird, ob ein wolkenfreier Tag vorliegt oder nicht, muss dies durch einen zweiten Schritt bestätigt werden.

Hierzu gibt es verschiedene Varianten. Die erste Möglichkeit besteht darin, dass im zweiten Schritt die Tagesleistungskurve P(t) ausgewertet wird.

Die erste Methode für die Auswertung der Tagesleistungskurve P(t) besteht darin, dass der Tagesenergiebetrag Etag bestimmt und mit einem vorgegebenen Mindestwert verglichen wird. Übersteigt der Tagesenergiebetrag Etag den Mindestwert, so ist ein Tag ohne Wolken sicher festgestellt worden.

Die zweite Auswertemethode im zweiten Schritt besteht darin, dass Extremwerte der Leistungskurve P(t) ausgewertet werden. Dazu wird aus der innerhalb des Tages gemessenen Datenschaar P(t) ein Absolutwert der Leistung Pabs ermittelt. Dieser kann beispielsweise der Maximalwert Pmax der Leistung P(t) für den beobachteten Tag oder aber auch ein Mittelwert aus mehreren Leistungsmaxima sein. Liegt dieser Wert Pabs innerhalb eines Toleranzbandes von Pabs_min bis P abs_max, dann ist es plausibel, dass es sich um einen vergleichbaren wolkenfreien Tag handelt. Hierbei wird auch indirekt die Einstrahlungsintensität und Dauer berücksichtigt, ohne dass ein zusätzlicher Sensor erforderlich ist.

Dieses Verfahren kann noch durch Hinzuziehen der Messung bzw. der Messwerte von Modul- und/oder Außentemperatur verfeinert werden.

**Patentansprüche**

1. Auswerteverfahren zur Bestimmung einer durch Alterung hervorgerufenen Leistungsreduzierung von mindestens einem Photovoltaikmodul bei gleichbleibender Strahlungsintensität mit einer Messung einer nach einer Zeit veränderbaren elektrischen Größe wie Zellenstrom, Zellenspannung und/oder Zellenleistung, **gekennzeichnet durch**

   - Festlegung mindestens einer jahresweise vergleichbaren Klasse k, innerhalb der eine Tagesleistungskurve oder Teilbereiche der Tagesleistungskurve des Photovoltaikmoduls aufgrund der zu erwartenden Einstrahlungsintensität und der Außentemperatur sowie der Einstrahlungsdauer vergleichbar sind, wobei die Klasse k einem definierten Zeitbereich eines Jahres entspricht,
   - Messung von jahresweise vergleichbaren Energieertragswerten Ek,n aus einem vergleichbaren Leistungsverlauf Pk,n (t) **durch** die vom Photovoltaikgenerator gelieferte Größe, so dass Energieabweichungen auf Basis der Klassen k bestimmt werden, wobei n das jeweilige Jahr ist,
   - Angabe einer Leistungsreduzierung des Photovoltaikmoduls bezüglich eines oder mehrerer Vorjahre aus dem von dem Photovoltaikmodul unmittelbar gelieferten Energieertragwertes E k,n **durch** eine Differenzbildung zu den Energieerträgen Ek,i der zu vergleichenden Jahre i.

2. Auswerteverfahren nach Anspruch 1 oder 2,
   **gekennzeichnet durch**
   Erfassen und/oder Ablegen einer Tagesverlaufskurve der Leistung P(t) des Generators sowie des Energieertrages E des Tages für den Generator, insbesondere in einer Datenbank,
   Bestimmung einer Tagesleistungskurve Pk,n(t), die in ihrem Verlauf mit mindestens einer Tageskurve Pk,i(t) aus den Vorjahren i vergleichbar ist und
   Ablegen der gefundenen Tagesleistungskurve Pk,n(t) und des Energieertrages Ek,n in einer Datenbank.

3. Auswerteverfahren nach einem der vorhergehenden Ansprüche,
   **gekennzeichnet durch**
   Bildung von Tagesklassen kj, die festen Zeitintervallen eines Tages zugeordnet sind.

4. Auswerteverfahren nach einem der vorhergehenden Ansprüche,
   **gekennzeichnet durch**
   Bildung und Auswertung einer ersten Ableitung der Funktion P (t).

5. Auswerteverfahren nach Anspruch 4,
   **gekennzeichnet durch**
   Bestimmung vergleichbarer Tage in einem Schritt **dadurch**, dass die Zahl die Nulldurchgänge der ersten Anleitung P'(t) bestimmt und auswertet wird.

6. Auswerteverfahren nach Anspruch 4,
   **gekennzeichnet durch**
   Bestimmung vergleichbarer Tage in zwei Schritten **dadurch**, dass

   a. die erste Ableitung P'(t) der Funktion P(t) **durch** ein erstes Kriterium ausgewertet wird und
   b. die Tagesleistungskurve P(t) **durch** ein zweites Kriterium ausgewertet wird.

7. Auswerteverfahren nach Anspruch 4 oder 6,
   **gekennzeichnet durch**
   **das** erste Kriterium für die Auswertung der ersten Ableitung P'(t) **dadurch**, dass die Extremwerte der ersten Ableitung P'(t) einen oberen Grenzwert P'max nicht überschreiten und einen unteren Grenzwert P'min nicht unterschreiten oder dass
   die von der Kurve der ersten Ableitung P'(t) eingeschlossenen Fläche einen festgelegten Grenzwert nicht überschreitet.

8. Auswerteverfahren nach einem der Ansprüche 4 oder 7,
   **gekennzeichnet durch**
   **das** zweite Kriterium für diese Auswertung der Tagesleistungskurve P(t) **dadurch**, dass der Tagesenergieertrag Etag gebildet wird und dieser oberhalb eines festgelegten Grenzwerts liegt oder dass
   das Maximum der Tagesleistungskurve P(t) innerhalb eines Toleranzbandes Pabs_min und Pabs max liegt.

**9.** Auswerteverfahren nach einem der vorhergehenden Ansprüche,
**gekennzeichnet durch**
Bestimmung einer Tagesleistungskurve P(t), die im Wesentlichen nur ein Tagesleistungsmaximum aufweist.

**10.** Auswerteverfahren nach einem der vorhergehenden Ansprüche,
**gekennzeichnet durch**
Vorgabe von Grenzwerten im ersten Jahr der Messung und Verifizierung der Grenzwerte in den folgenden Jahren.

**11.** Auswerteverfahren nach einem der vorhergehenden Ansprüche,
**gekennzeichnet durch**
Ermittlung mindestens eines Mittelwertes $\Delta$mittel,n aus den k
Energieabweichungswerten $\Delta Ek,n$ für das Jahr n als Maß für die Leistungsreduzierung.

**12.** Solar-Anlage mit Mitteln zur Durchführung des Messverfahrens nach einem der vorhergehenden Ansprüche.


**Geänderte Patentansprüche gemäss Regel 137(2) EPÜ.**


**1.** Auswerteverfahren zur Bestimmung einer durch Alterung hervorgerufenen Leistungsreduzierung von mindestens einem Photovoltaikmodul bei gleichbleibender Strahlungsintensität mit einer Messung einer nach einer Zeit veränderbaren elektrischen Größe wie Zellenstrom, Zellenspannung und/oder Zellenleistung, ohne zusätzliche Sensoren zur Messung der Strahlungsintensität,
mit folgenden Schritten

- Festlegung mindestens einer jahresweise vergleichbaren Klasse k, innerhalb der eine Tagesleistungskurve oder Teilbereiche der Tagesleistungskurve des Photovoltaikmoduls aufgrund der zu erwartenden Einstrahlungsintensität und der Außentemperatur sowie der Einstrahlungsdauer miteinander vergleichbar sind, wobei die Klasse k einem definierten Zeitbereich eines Jahres entspricht,
- Messung von jahresweise vergleichbaren Energieertragswerten Ek,n aus einem vergleichbaren Leistungsverlauf Pk,n (t) durch die vom Photovoltaikgenerator gelieferte Größe, so dass Energieabweichungen auf Basis der Klassen k bestimmt werden, wobei n das jeweilige Jahr ist,
- Angabe einer Leistungsreduzierung des Photovoltaikmoduls bezüglich eines oder mehrerer Vorjahre aus dem von dem Photovoltaikmodul unmittelbar gelieferten Energieertragwert E k,n durch eine Differenzbildung zu den Energieerträgen Ek,i der zu vergleichenden Jahre i,
- wobei Daten vergleichbarer Tage mit vergleichbarer Leistungskurve P(t) des Photovoltaikmoduls über mehrere Jahre hinweg beobachtet werden.

| Jahr\Klasse | 1 | 2 | ... | K |
|---|---|---|---|---|
| 1 | $E_{1,1}$ | $E_{2,1}$ | ... | $E_{K,1}$ |
| 2 | $E_{1,2}$ | $E_{2,2}$ | ... | $E_{K,2}$ |
| $\vdots$ | $\vdots$ | $\vdots$ | | $\vdots$ |
| n | $E_{1,n}$ | $E_{2,n}$ | ... | $E_{K,n}$ |

$$\Delta E_{1,n} = E_{1,1} - E_{1,n} \qquad \Delta E_{2,n} = E_{2,1} - E_{2,n} \qquad \ldots \qquad \Delta E_{K,n} = E_{K,1} - E_{K,n}$$

$$\Delta E_{1,n}^{*} = \frac{\Delta E_{1,n}}{E_{1,1}} \qquad \Delta E_{2,n}^{*} = \frac{\Delta E_{2,n}}{E_{2,1}} \qquad \ldots \qquad \Delta E_{K,n}^{*} = \frac{\Delta E_{K,n}}{E_{K,1}}$$

**Fig. 1a**

| Klasse Jahr | 1 | 2 | ... | K |
|---|---|---|---|---|
| 1 | $E_{1,1} - E_{1,2}$ | $E_{2,1} - E_{2,2}$ | ... | $E_{K,1} - E_{K,2}$ |
| 2 | $E_{1,2} - E_{1,3}$ | $E_{2,2} - E_{2,3}$ | ... | $E_{K,2} - E_{K,3}$ |
| ⋮ | ⋮ | ⋮ | | ⋮ |
| n | $E_{1,n-1} - E_{1,n}$ | $E_{2,n-1} - E_{2,n}$ | ... | $E_{K,n-1} - E_{K,n}$ |

**Fig. 1b**

Pac

## Fig. 2a

## Fig. 2b

## Fig. 2c

Pac

## Fig. 3a

## Fig. 3b

## Fig. 3c

Pac

## Fig. 4a

## Fig. 4b

## Fig. 4c

**Europäisches Patentamt**

**EUROPÄISCHER RECHERCHENBERICHT**

Nummer der Anmeldung

EP 07 02 4889

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | PRATT R G ET AL: "Performance of a 4 kW amorphous-silicon alloy photovoltaic array at Oakland Community College, Auburn Hills, Michigan" 19880926; 19880926 - 19880930, 26. September 1988 (1988-09-26), Seiten 1272-1277, XP010750513 * das ganze Dokument * ----- | 1-4,9-12 | INV. G01R31/26 G05F1/67 |
| A | WO 03/098703 A (ROEHRIG RUEDIGER [DE]; STEGER JOSEF [DE]) 27. November 2003 (2003-11-27) * Abbildungen 1,2,5 * * Seite 1, Zeile 1 - Zeile 19 * * Seite 13, Zeile 4 - Seite 14, Zeile 7 * * Seite 15, Zeile 4 - Seite 17, Zeile 8 * * Seite 18, Zeile 4 - Zeile 18 * * Seite 18, Zeile 28 - Seite 19, Zeile 27 * ----- | 1-12 | |
| A | WENGER H J ET AL: "Decline of the Carrisa Plains PV power plant: the impact of concentrating sunlight on flat plates" PROCEEDINGS OF THE PHOTOVOLTAIC SPECIALISTS CONFERENCE. LAS VEGAS, OCT. 7 - 11, 1991; [PROCEEDINGS OF THE PHOTOVOLTAIC SPECIALISTS CONFERENCE], NEW YORK, IEEE, US, Bd. CONF. 22, 7. Oktober 1991 (1991-10-07), Seiten 586-592, XP010039235 ISBN: 978-0-87942-636-1 * das ganze Dokument * ----- -/-- | 1-12 | **RECHERCHIERTE SACHGEBIETE (IPC)** G01R G05F H01L |

Der vorliegende Recherchenbericht wurde für alle Patentansprüche erstellt

| Recherchenort | Abschlußdatum der Recherche | Prüfer |
|---|---|---|
| Berlin | 4. Juni 2008 | Höller, Helmut |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches Patentamt**

# EUROPÄISCHER RECHERCHENBERICHT

Nummer der Anmeldung

EP 07 02 4889

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | R N ET AL: "Field studies of performance & reliability of heterogeneous 2 photo-voltaic modules for optimum array design" EEDINGS OF THE PHOTOVOLTAIC SPECIALISTS CONFERENCE. LAS VEGAS, OCT. 7 19911007; 19911007 - 19911011 NEW YORK, IEEE, US, Bd. CONF. 22, 7. Oktober 1991 (1991-10-07), Seiten 689-694, XP010039302 ISBN: 978-0-87942-636-1 * das ganze Dokument * ----- | 1-12 | |
| A | TUCKER R T ET AL: "A review of field performance of EVA-based encapsulants" CONFERENCE RECORD OF THE 29TH IEEE PHOTOVOLTAIC SPECIALISTS CONFERENCE 20020519; 20020519 - 20020524 NEW YORK, NY : IEEE, US, Bd. CONF. 29, 19. Mai 2002 (2002-05-19), Seiten 1703-1706, XP010666617 ISBN: 978-0-7803-7471-3 * das ganze Dokument * ----- | 1-12 | RECHERCHIERTE SACHGEBIETE (IPC) |
| A | US 2004/264225 A1 (BHAVARAJU VIJAY [US] ET AL) 30. Dezember 2004 (2004-12-30) * Abbildung 2 * * Absätze [0001], [0005], [0008] * * Absatz [0022] - Absatz [0023] * * Absatz [0033] * * Absatz [0037] - Absatz [0041] * * Absatz [0055] * ----- | 1-12 | |
| A | EP 0 534 473 A (CANON KK [JP]) 31. März 1993 (1993-03-31) * Spalte 19, Zeile 16 - Zeile 26 * * Spalte 20, Zeile 7 - Zeile 24 * ----- -/-- | 1-12 | |

Der vorliegende Recherchenbericht wurde für alle Patentansprüche erstellt

| Recherchenort | Abschlußdatum der Recherche | Prüfer |
|---|---|---|
| Berlin | 4. Juni 2008 | Höller, Helmut |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

**Europäisches Patentamt**

**EUROPÄISCHER RECHERCHENBERICHT**

Nummer der Anmeldung

EP 07 02 4889

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 5 439 533 A (SAITO KEISHI [JP] ET AL) 8. August 1995 (1995-08-08) <br> * Spalte 28, Zeile 58 - Spalte 29, Zeile 10 * <br> * Spalte 39, Zeile 31 - Spalte 40, Zeile 8 * <br> * Spalte 72, Zeile 20 - Zeile 60 * <br> ----- | 1-12 | |
| A | US 5 648 731 A (DECKER DARWIN KENT [US] ET AL) 15. Juli 1997 (1997-07-15) <br> * Spalte 11, Zeile 6 - Zeile 36 * <br> ----- | 1-12 | |
| | | | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| Berlin | 4. Juni 2008 | Höller, Helmut |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 

& : Mitglied der gleichen Patentfamilie, übereinstimmendes Dokument

EPO FORM 1503 03.82 (P04C03)

EP 2 077 453 A1

**ANHANG ZUM EUROPÄISCHEN RECHERCHENBERICHT**
**ÜBER DIE EUROPÄISCHE PATENTANMELDUNG NR.**   EP 07 02 4889

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-06-2008

| Im Recherchenbericht angeführtes Patentdokument | Datum der Veröffentlichung | Mitglied(er) der Patentfamilie | Datum der Veröffentlichung |
|---|---|---|---|
| WO 03098703 A | 27-11-2003 | AU 2003232634 A1<br>DE 10222621 A1<br>DE 10393094 D2<br>EP 1552563 A2<br>JP 2005528071 T<br>US 2005172995 A1 | 02-12-2003<br>27-11-2003<br>12-05-2005<br>13-07-2005<br>15-09-2005<br>11-08-2005 |
| US 2004264225 A1 | 30-12-2004 | KEINE | |
| EP 0534473 A | 31-03-1993 | AU 650784 B2<br>AU 2536992 A<br>DE 69217791 D1<br>DE 69217791 T2<br>JP 2994812 B2<br>JP 5090620 A<br>US 5352300 A | 30-06-1994<br>01-04-1993<br>10-04-1997<br>28-08-1997<br>27-12-1999<br>09-04-1993<br>04-10-1994 |
| US 5439533 A | 08-08-1995 | KEINE | |
| US 5648731 A | 15-07-1997 | US 5530335 A | 25-06-1996 |

Für nähere Einzelheiten zu diesem Anhang : siehe Amtsblatt des Europäischen Patentamts, Nr.12/82

EPO FORM P0461

18